(19)

Europäisches
Patentamt
European
Patent Office
Office européen
des brevets

(11) **EP 3 680 626 A1**

(12) **EUROPEAN PATENT APPLICATION**

(43) Date of publication:
**15.07.2020 Bulletin 2020/29**

(51) Int Cl.:
**G01F 1/58** (2006.01)    **G01F 1/60** (2006.01)
**G01N 27/08** (2006.01)

(21) Application number: **20150468.5**

(22) Date of filing: **07.01.2020**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **09.01.2019 US 201916243980**

(71) Applicant: **Georg Fischer Signet LLC
El Monte, CA 91734 (US)**

(72) Inventors:
• **Ciobanu, Calin
  Brea, CA 92821 (US)**
• **Wells, Steven
  Huntington Beach, CA 92647 (US)**

(74) Representative: **Fenner, Seraina
  Georg Fischer AG
  Amsler-Laffon-Strasse 9
  8201 Schaffhausen (CH)**

(54) **MAGNETIC FLOWMETER WITH MEDIA CONDUCTIVITY MEASUREMENT**

(57)    A magnetic flowmeter assembly for measuring the velocity of a conductive fluid in a flow path. The flowmeter assembly includes a coil driver for providing a drive current to a coil assembly, an electrode for measuring an electrical signal created by the conductive fluid flowing through a magnetic field created by the coil assembly, and a micro-processor for controlling the magnetic flowmeter. The micro-processor determines the electrical conductivity of the fluid based on the sensed electrical signal. The micro-processor then modifies the frequency of the coil driver in response to the fluid's electrical conductivity to optimize the sampling rate of the flowmeter. The flowmeter assembly modifies the coil driver frequency by either increasing the drive frequency for highly conductive fluids or decreasing the drive frequency for less conductive fluids.

FIG. 1

**Description**

**FIELD OF THE INVENTION**

The present invention relates generally to the operation of sensors for measuring the velocity of fluids and more particularly to magnetic flowmeters for performing fluid flow measurements.

**BACKGROUND OF THE INVENTION**

Magnetic flow meters measure the velocity of conductive fluids passing through pipes by generating a magnetic field and measuring the resultant voltage. These flowmeters rely upon Faraday's Law in which the flow of a conductive fluid through a magnetic field causes a voltage signal which is sensed by electrodes. The sensed voltage is proportional to the velocity of the fluid.

Although these flowmeters are generally effective, shortfalls exist. For example, one limitation with current flowmeters is that the fluid media being measured must meet a minimum electrical conductivity level. If a fluid media falls below this minimum conductivity value it cannot be accurately measured. Furthermore, for fluids with low conductivity the sensed voltage $U_E$ must be given sufficient time to settle so that an accurate voltage measurement can be achieved. This time delay can be significant for low conductivity fluids and adversely affect the magnetic flow meter's sampling rate. This reduced sampling rate can in turn affect the measurement accuracy in applications where the fluid velocity changes rapidly and is non-continuous.

It should, therefore, be appreciated there is a need for a magnetic flowmeter assembly that addresses these concerns. The present invention fulfills these needs and others.

**SUMMARY OF THE INVENTION**

Briefly and in general terms, the present invention provides a system and related method for measuring the conductivity of a fluid media being measured by a magnetic flowmeter.

The system comprises a coil driver for providing a drive current to a coil assembly, an electrode for measuring an electrical signal created by a conductive fluid flowing through a magnetic field created by the coil assembly, and a micro-processor for controlling the magnetic flowmeter. The micro-processor determines the electrical conductivity of the fluid in response to the sensed electrical signal. The micro-processor then modifies the frequency of the coil driver responsive to the electrical conductivity of the fluid in order to optimize the flowmeter's sampling rate. Specifically, the flowmeter modifies the coil driver frequency by either increasing the drive frequency for highly conductive fluids or decreasing the drive frequency for less conductive fluids.

For purposes of summarizing the invention and the advantages achieved over the prior art, certain advantages of the invention have been described herein. It is to be understood that not necessarily all such advantages may be achieved in accordance with any particular embodiment of the invention. Thus, for example, those skilled in the art will recognize that the invention may be embodied or carried out in a manner that achieves or optimizes one advantage or group of advantages as taught herein without necessarily achieving other advantages as may be taught or suggested herein.

All of these embodiments are intended to be within the scope of the invention disclosed herein. These and other embodiments of the present invention will become readily apparent to those skilled in the art from the following detailed description of the preferred embodiments having reference to the attached figures, the invention not being limited to any particular preferred embodiment disclosed.

In one embodiment, energizing at least one coil assembly comprises alternating the drive current to induce a magnetic field in the at least one coil assembly.

In a variant, measuring an electrical property of the conductive fluid in the fluid flow path comprises measuring a peak voltage ($U_E$ Peak) induced in the conductive fluid by a magnetic field created by the at least one coil assembly.

In one embodiment, adjusting a frequency of the drive current comprises increasing the frequency of the drive current for higher conductivity fluids and decreasing the frequency of the drive current for lower conductivity fluids.

**BRIEF DESCRIPTION OF THE DRAWINGS**

Embodiments of the present invention will now be described, by way of example only, with reference to the following drawings:

FIG. 1 is a simplified perspective view of a magnetic flowmeter assembly in accordance with the present invention.

FIG. 2 illustrates a time varying voltage ($U_E$) created by the conductive fluid traveling through the flow path of the magnetic flowmeter.

FIG. 3 illustrates the relationship between a measured peak voltage $U_E$ peak (mV) and a fluid's electrical conductivity ($\mu$S/cm).

FIG. 4 is a simplified diagram of a magnetic flowmeter system for measuring the conductivity of a fluid and optimizing its operation.

FIG. 5 illustrates a time varying drive voltage (V) which is applied to the coil assemblies.

FIG 6 illustrates a time varying drive current (I) which propagates through the coil assemblies

FIG 7 illustrates a time varying magnetic field (B) created by the coil assemblies within the fluid flow path.

FIG. 8 illustrates a time varying voltage signal ($U_E$) induced in the conductive fluid and detected by the electrodes.

FIG.9 depicts a non-optimized voltage signal ($U_E$) illustrating the time delay $T_D$, steady state time Ts and total measurement time $T_T$.

FIG. 10 depicts an optimized time varying voltage signal ($U_E$) in which the steady state time Ts has been reduced by increasing the drive current (I) frequency.

FIG. 11 illustrates how the drive current frequency is optimized based on the fluid media's conductivity.

FIG. 12 depicts a method for modifying the frequency of the drive current (I) in accordance with one embodiment of the present invention.

FIG. 13 is a simplified perspective view of a magnetic flow meter assembly in accordance with the present invention, including a brace coupled to a pair of coils forming magnetic circuitry circumscribing the pipe.

FIG. 14 is a simplified perspective view of a magnetic flow meter assembly of FIG. 13, further comprising a shield housing and electronics assembly.

## INCORPORATION BY REFERENCE

In certain embodiments of the present invention, the magnetic flowmeter assembly can be configured as described and claimed in Applicant's co-pending patent application, entitled "FULL BORE MAGNETIC FLOWMETER ASSEMBLY, U.S. App. No. 16/146,090, filed September 28, 2018, which is hereby incorporated by reference for all purposes.

## DETAILED DESCRIPTION OF THE PREFERRED EMBODIMENTS

The conductivity of a fluid is its ability to conduct an electric current. A fluid's electrical conductivity is typically measured in Siemens per meter (S/m). A fluid's conductivity is generally a function of the total dissolved solids (TDS) in the fluid. For example, pure deionized water has a conductivity of approx. 5.5 $\mu$S/m while sea water with dissolved salts and other impurities has a conductivity of approx. 5 S/m (i.e., sea water is one million times more conductive than deionized water).

The conductance (C) of a fluid solution depends upon the strength and concentration of the electrolytes in the solution. Strong electrolytes typically include strong acids (e.g., HCl, $H_2SO_4$, $HNO_3$), strong bases (e.g., LiOH, NaOH, KOH) and/or salts (e.g., NaCL, $KNO_3$, $MgCl_2$). These electrolytes completely ionize or disassociate in the solution and the suspended ions are good electrical conductors. In contrast, weak electrolytes never fully disassociate in the solution (i.e., form a mixture of ions and molecules in equilibrium). Weak electrolytes generally include weak acids (e.g., acetic acid, $CH_3COOH$ and phosphorous acid ($H_3PO_4$) and/or weak bases (e.g., $NH_3$). In weak electrolytic solutions the concentration of ions is less than the concentration of the electrolyte itself.

The electrical conductance (C) of a solution is determined by measuring the resistance (R) of the solution between two electrodes which are separated by a fixed distance (*l*) with a conductivity meter.

$$R = \frac{1}{C} = \frac{l\,\rho}{A}$$

Where:

R = resistance
C = Conductance
*l* = distance between the electrodes
$\rho$ = specific electrical resistance of the fluid
A = cross sectional area of the test sample

As a rule of thumb, the minimum electrical conductivity of a fluid being measured with a magnetic flowmeter is 5 micro S/cm. Solutions with lower conductivities generally have voltage signals ($U_E$) which are challenging to detect and difficult to measure accurately. Alternatively, fluids with high electrical conductivities have voltage signals ($U_E$) which are consistent over time, have well defined voltage signals, and can be accurately measured.

Magnetic flowmeters rely upon Faraday's Law of Electromagnetic Induction to measure the velocity of the conductive fluid in flow path. Specifically, Faraday's Law states that the voltage induced across any conductor that moves at right angles through a magnetic field is proportional to the velocity of the conductor.

$$U_E \sim V \times B \times L$$

Where:

$U_E$ = inducted voltage (i.e., signal voltage)
V = average velocity of conductive fluid
B = magnetic field strength
L = length of the conductor (i.e., distance between electrodes)

Alternatively, the fluid velocity $V \sim \dfrac{U_E}{B \times L}$

The flow of the conductive liquid passing through the magnetic field B creates a voltage signal $U_E$ which is sensed by the pair of measuring electrodes and which in-turn can be used to calculate the average velocity V of the fluid. Magnetic flow meters are generally very accurate (e.g., < 1% measurement error).

As Faraday's equation illustrates, the average fluid velocity V is directly proportional to the induced voltage $U_E$. We'll see shortly that the induced peak voltage ($U_E$ Peak) is a function of the fluid's electrical conductivity C. This relationship between induced peak voltage $U_E$ Peak and fluid conductivity C enables a fluid's electrical conductivity to be determined and operation of a magnetic flowmeter to be optimized based on the fluid media's conductivity.

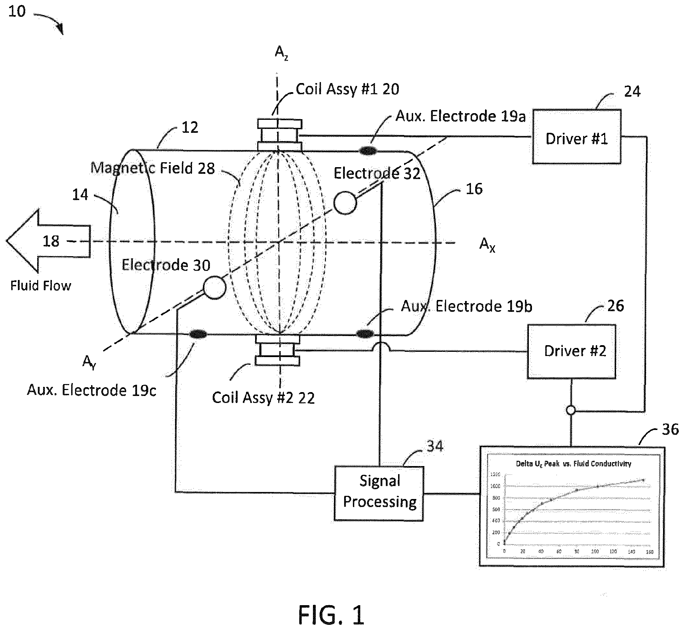

Referring now to the drawings, and in particular FIG. 1, there is shown a magnetic flowmeter assembly 10 having the novel fluid conductivity measurement system. The magnetic flow meter assembly 10 has a tubular body 12 (e.g., pipe) with two opposing ends 14 and 16 which are aligned along a horizontal axis ($A_x$) and which define a fluid flow path 18 for transporting a conductive fluid. The magnetic flow meter assembly 10 includes a pair of coil assemblies (20, 22) which are coupled to an intermediate region of the flow meter 10 and are configured to pass a current received from a pair of coil drivers (24, 26). The coil assemblies (20, 22) generate a magnetic field 28 within the fluid flow path 18 of the tubular body 12 via the current passing therein. A pair of measuring electrodes (30, 32) attached to the body 12 are configured to detect a voltage induced by the conductive fluid passing through the magnetic field 28. The detected voltage signals are processed by a signal processor 34 which provides a digital signal to a micro-processor 36 which processes the signal data and determines the electrical conductivity C of the fluid media.

With continued reference to FIG.1, in an alternate embodiment the coil assemblies (20, 22) can be externally coupled to the tubular body 12 and aligned along vertical axis ($A_Z$) which is orthogonal to the longitudinal ($A_x$) and horizontal ($A_Y$) axes. The magnetic flowmeter assembly 10 can further include a plurality of auxiliary electrodes 19 (a, b, c), including a first auxiliary electrode 19(a) and a second auxiliary electrode 19(b) that are disposed upstream of the pair of measuring electrodes (30, 32). The first and second auxiliary electrodes (19a, 19b) are aligned with vertical axis (Az), on opposing sides of the pipe, such that axis (Ay) and axis (Az) are coplanar. A third auxiliary electrode 19(c) is disposed downstream of the pair of measuring electrodes (30, 32). The measuring electrodes and the auxiliary electrodes are each mounted to a corresponding aperture formed in the wall of the pipe 12.

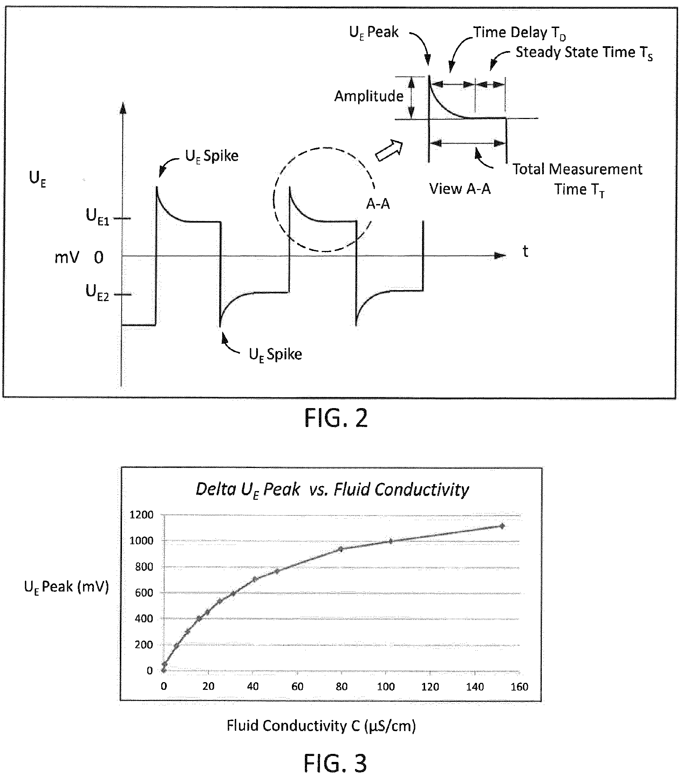

FIG.2 is an illustration of a time varying voltage signal $U_E$ that sensed by the pair of electrodes (30, 32). The time varying voltage signal $U_E$ is created when the conductive fluid 18 flows through the magnetic field (B) 28 created by the pair of coil assemblies (20, 22). Note that $U_E$ spikes each time the magnetic field B crosses zero (i.e., magnitude of magnetic field goes to zero). Referring to View A-A, the inventors have discovered that the amplitude of $U_E$ Peak (i.e., height above the steady state $U_E$ value) is proportional to the conductivity of the fluid media. Accordingly, based upon the geometry of the magnetic flowmeter the conductivity of the fluid media can be accurately determined based upon the amplitude of $U_E$ peak.

It's also been discovered that the time delay ($T_D$) which is the time necessary for the induced voltage $U_E$ measurement to settle and plateau (i.e., reach steady state) is greater for low conductivity fluids than for high conductivity fluids. The steady state time ($T_S$) is the time during which an accurate flow measurement can be performed. As illustrated in FIG. 2, the time delay $T_D$ can account for a significant portion of the total measurement time $T_T$. Accordingly, when measuring the velocity of high conductivity fluids, the total measurement time can be reduced (i.e., measurement frequency increased) and when measuring low conductivity fluids, the total measurement time can be increased (i.e., measurement frequency decreased). The ability to tailor the measurement frequency based on the fluid's conductivity is a significant advantage over prior fluid measurement systems. Particularly when measuring non-steady state fluids (i.e., fluids with widely varying flow velocities) or fluids with widely varying conductivities (i.e., different batches of fluid media or different fluid compositions).

FIG. 3 illustrates the relationship between the amplitude of $U_E$ peak (mV) as a function of fluid conductivity ($\mu$S/cm). It can be seen that the amplitude of $U_E$ peak increases approximately log-rhythmically with fluid conductivity. Accordingly, highly conductive fluids have tall, well defined signal peaks and low conductivity fluids have much less defined signal peaks that can be much more challenging to detect and measure. Using this relationship, we can determine the conductivity of a fluid media based upon the amplitude of "$U_E$ peak". It should be appreciated that while we are showing the relationship between $U_E$ peak and fluid conductivity C graphically, the relationship could also be recorded in a lookup table, a mathematical relationship, or other mathematical means that can be stored in computer memory and processed or accessed by a micro-processor.

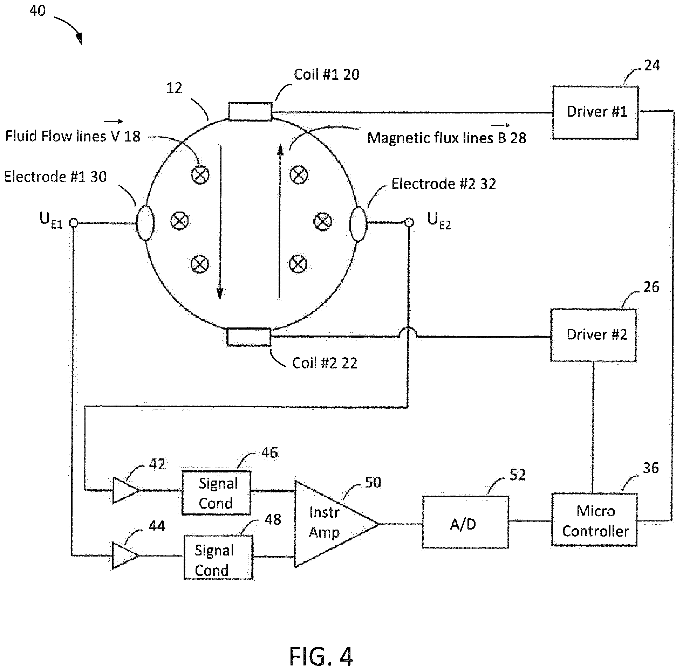

FIG. 4 is a simplified diagram of a magnetic flowmeter system 40 for measuring the conductivity of a fluid media and optimizing its operation. The system includes a tubular body 12 which forms a fluid conduit for transporting the conductive fluid 18. The system further includes two coil assemblies (20, 22) which are energized by a pair of coil drivers (24, 26) which generate a time varying magnetic field 28 across the conductive fluid 18.

The two coil drivers (24, 26) are energy management IC's which provide an active power pulse output. The coil drivers can be embodied as H bridge drivers, configured with very low resistance and thus low voltage drop. As such, the coil drivers are capable of alternating the direction of the current passing through each coil assembly, and thereby impacting the direction of the magnetic field emitted from each coil. Alternating the direction of the current, and thus magnetic field, is implemented so as to avoid the electrochemical phenomenon of electrode migration. The coil drivers have an integrated on-chip voltage reference, ultra-low temperature drift (< 15 ppm/C°) and are highly reliable.

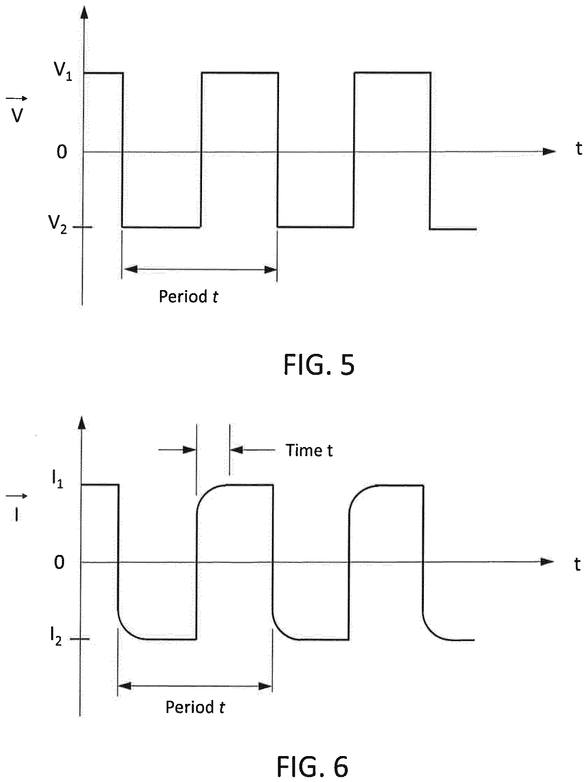

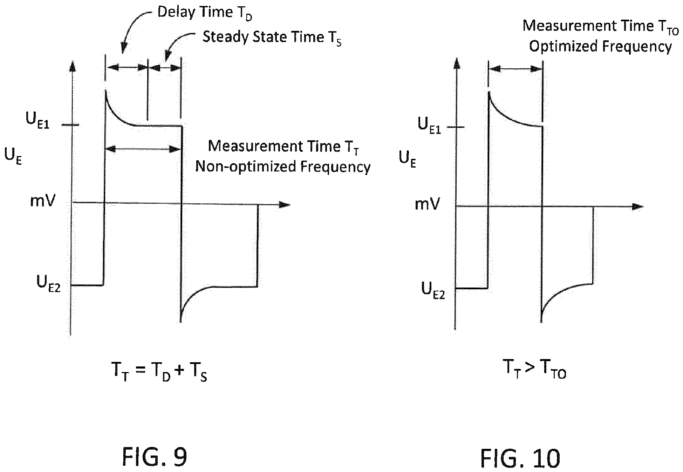

A pair of electrodes (30, 32) measure the voltage signal $U_E$ induced in the conductive fluid 18 by the magnetic field 28. The voltage signal is run through a pair of diodes (42, 44), signal conditioners (46, 48), and an instrumentation amp (50) which measures the induced voltages ($U_{E1}$, $U_{E2}$) across the fluid. The instrumentation amp (50) amplifies the signal and maintains a linear relationship between the input current ($I_1$, $I_2$) and output voltage ($V_{E1}$, $V_{E2}$). An A to D converter (ADC) (52) receives the analog output from the instrumentation amp (50) and converts it into a digital signal. A micro-processor (36) receives the digital signal, processes the data using instructions stored in memory and determines the conductivity of the fluid media based on the digital signal. The micro-processor then determines the optimal frequency of the drive current (I) based on the conductivity measurement. The two coil drivers (24, 26) then use the optimal drive frequency to energize the two coil assemblies (20, 22) as illustrated in FIG. 6. This results in an optimized time varying voltage ($U_E$) as illustrated in FIG. 10.

With reference to FIGS. 5, 6, 7, 8, 9 and 10 we'll explain how the control system optimizes the frequency of the drive current (I) once the conductivity of the fluid media has been determined.

With reference to FIG. 5, is a depiction of an alternating drive voltage V with magnitudes ($V_1$, $V_2$) and period $\tau$ which is provided to the coil assemblies. When the coil assemblies are driven by the alternating voltage V an alternating current I is created in the coils with magnitudes ($I_1$, $I_2$) and period $\tau$ as illustrated by FIG. 6. Note that depending upon the circuits R/L ratio it takes time (t) for the current I to achieve a constant value.

The following equation illustrates the relationship between the coil's current I, resistance R and inductance L.

$$I = V/R*[1-e^{\wedge}(-) R/L*t]$$

Where:

V = applied drive voltage

R = coil resistance
L = coil inductance
t = time

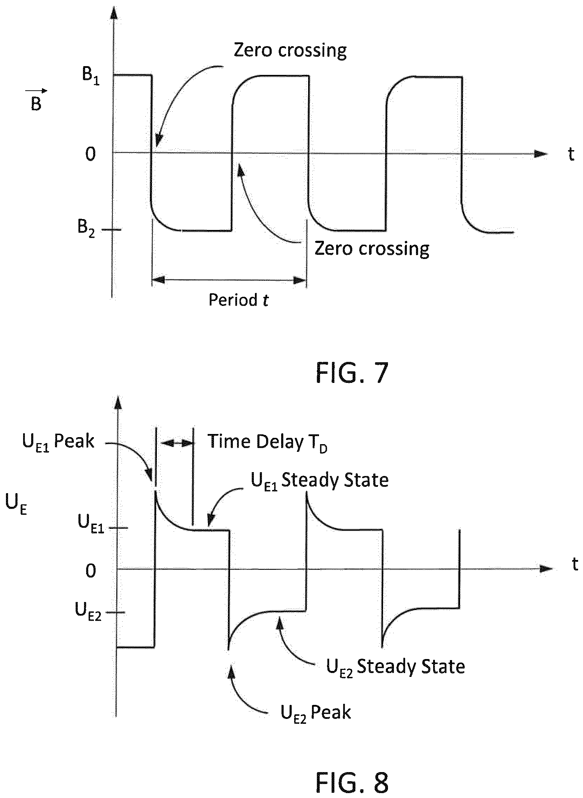

An illustrative time varying magnetic field B generated within the flow field is shown in FIG. 7. The magnetic field B is generated by the current I flowing in alternating directions through each coil assembly. The magnitude of B ($B_1$, $B_2$) is proportional to the drive current I and the number of coil turns.

$$\vec{B} \sim \vec{I} \times N$$

Where:

I = applied drive current
R = number of coil turns

With reference to FIG. 8, is an illustration of the sensed voltage $U_E$ generated by the time varying magnetic field B which flows perpendicular to the fluid flow lines V and which is detected by the pair of electrical electrodes. Note that $U_E$ spikes when the time varying magnetic field B crosses the zero (see FIG. 7 zero crossing). The magnitude of $U_E$ peaks at the zero crossing and then settles into steady state values $U_{E1}$ and $U_{E2}$ following a short time delay ($T_D$). It's after this short time delay $T_D$ that $U_E$ achieves a steady state value (i.e., $U_{E1}$ Steady State) and when an accurate flow velocity measurement can be performed.

With reference to FIG. 9, is a depiction of the voltage $U_E$ profile generated using a non-optimal coil drive frequency. Note that the total measurement time $T_T$ includes both delay time $T_D$ and steady state time Ts.

$$T_T = T_D + T_S$$

The delay time $T_D$ is strongly dependent upon the fluid media's conductivity since it follows a conventional capacitor discharge profile. We saw earlier that a fluid's resistivity R is a function of the number of charge carriers. So, the lower the resistivity R, the shorter the discharge time (e.g., if R is high in an RC circuit, the time constant T is also high). Accordingly, the greater the conductivity of the fluid the shorter the delay time $T_D$. The steady state time Ts is the time during which $U_E$ is at a steady state value and the voltage measurement is performed. This time can also be optimized to achieve a greater measurement frequency.

With reference to FIG. 10, is an illustration of the sensed voltage $U_E$ generated using an optimized coil drive frequency. In this example the fluid media is highly conductive and the coil drive frequency has been increased to take advantage of the shorter delay time $T_D$ before the induced voltage $U_E$ achieves a steady state value. In this example the total measurement time $T_{TO}$ for the optimized process is significantly shorter than the total measurement time $T_T$ for the non-optimized process.

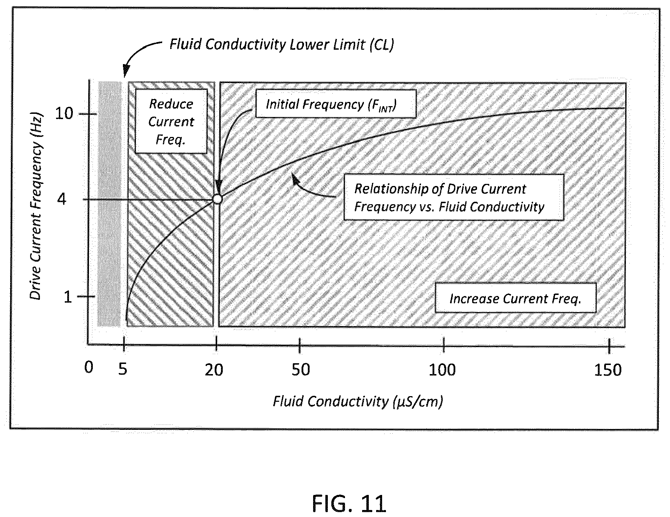

FIG. 11 illustrates a technique for optimizing the drive current frequency (i.e., approx. 1 to 10 Hz) based on a fluid media's conductivity. The magnetic flowmeter begins operation using an initial drive current frequency ($F_{Init}$) (i.e., 4 Hz) which provides a baseline operation parameter before a fluid conductivity measurement can be performed. Once the conductivity of the fluid has been determined, the conductivity value is compared to a lower conductivity limit (CL). The conductivity lower limit CL is a value below which an induced voltage $U_E$ cannot be accurately and repeatably measured. If the fluid conductivity is below this value the fluid velocity measurement is generally terminated. If the fluid conductivity value is above the conductivity lower limit CL, but below the conductivity value corresponding to the initial frequency $F_{Init}$, the drive frequency is typically reduced based upon the relationship between drive current frequency and fluid conductivity. This has the effect of providing additional time for the sensed voltage signal $U_E$ to settle and establish a steady state value resulting in more accurate velocity measurement. If the fluid conductivity measurement is above the conductivity value corresponding to the initial frequency $F_{Init}$, the drive frequency is typically increased based upon the relationship between drive current frequency and fluid conductivity. The higher coil drive frequency increases the data sampling rate without impacting the quality of the $U_E$ signal. This higher sampling rate can provide a significant advantage when the composition and/or flow rate of the fluid media is changing rapidly. It should be noted that while the relationship between drive current frequency and fluid conductivity is shown graphically. The relationship could also be recorded in a look-up table, a mathematical equation, a computer sub-routine, or any other method for recording a relationship between variables.

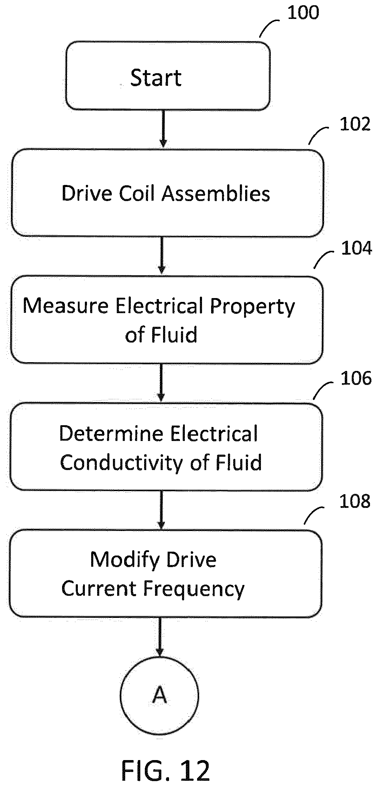

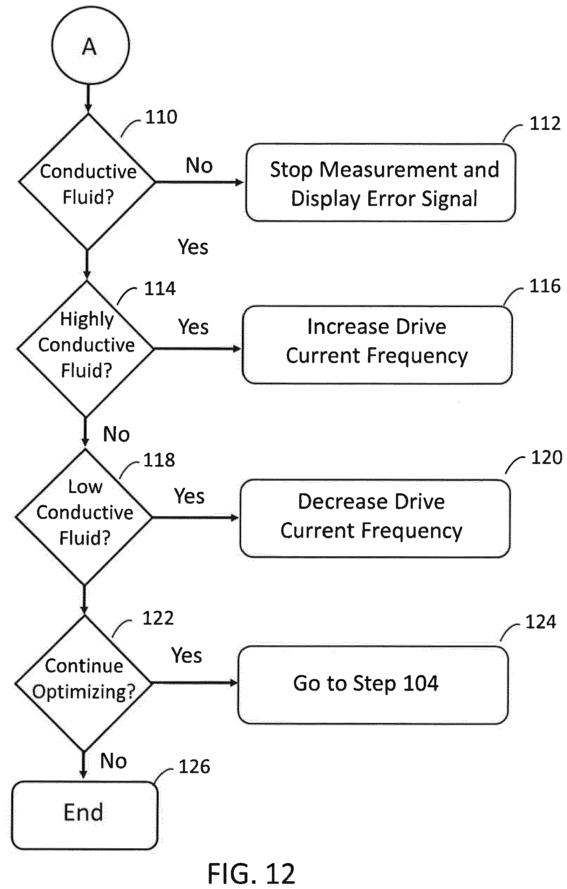

With reference to FIG. 12, a method for operating a magnetic flowmeter in accordance with the invention is described. The method begins by providing a drive current ($I_1$, $I_2$) to the two coil assemblies using the first and second coil drivers (Step 102). As illustrated in FIG. 6 the drive currents I have magnitudes $I_1$ and $I_2$, and period $\tau$. The drive currents energize the coil assemblies which generate a time varying magnetic field B across the fluid flow path as shown in FIG. 7.

The two electrodes sense the voltage $U_E$ created by the conductive fluid flowing perpendicular to the time varying magnetic field B as depicted in FIG.8 (Step 104). The voltage $U_E$ has peak values ($U_{E1\ Peak}$, $U_{E2\ Peak}$) indicative of the conductivity of the fluid media. The voltage signal also has steady state values ($U_{E1\ Steady}$, $U_{E2\ Steady}$) and a time delay $T_D$ for the signal to achieve a steady state value.

The voltage signal from one or both electrodes passes thru a diode and signal conditioner, and is then converted from an analog to digital signal using the A/D converter. The digital signal is received by a micro-processor which compares the amplitude of the peak voltage values ($U_{E1\ Peak}$, $U_{E2\ Peak}$) to a relationship between peak voltage and fluid electrical conductivity (See FIG. 3). As noted earlier, the relationship could be in the form of a graphical representation, a lookup table, a mathematical equation, or other recording means. From this relationship the micro-processor determines the electrical conductivity of the fluid (Step 106).

The micro-processor then modifies the drive current frequency based upon the fluid media's electrical conductivity (Step 108). The fluid's electrical conductivity is first compared to a minimum electrical conductivity for achieving accurate fluid velocity measurements (Step 110). If the fluid's electrical conductivity is below this threshold value, operation of the magnetic flow meter is typically paused and an error signal is displayed (Step 112). Alternatively, if the fluid's electrical conductivity is above the threshold value, the processor then determines whether the fluid's conductivity is high enough to warrant increasing the frequency of the drive current (Step 114). For example, if the fluid has a conductivity above 50 µS/cm the drive current frequency is increased to 5 Hz.

Next, if the fluid's electrical conductivity is above the threshold value, but too low to increase the drive current frequency, it's then determined whether a lower drive current frequency is warranted (Step 118). In instances where the induced voltage $U_E$ requires additional time to achieve a steady state value the frequency of the drive current I is decreased. This results in an increase in steady state time Ts and a more accurate and repeatable voltage measurement (Step 120). For example, if the fluid conductivity is below 15µS/cm the drive current frequency is decreased to 3 Hz. A fluid media that was previously subject to large fluid velocity measurement errors can now be accurately measured.

Once the drive frequency has been optimized for the current fluid media the novel method can be repeated at Step 124 or ended at Step 126 (Step 122). There are many reasons for continuing to perform the optimization process including: batch to batch variations in a fluid conductivity, regular changes in the fluid media being measured, or to ensure very fast and accurate fluid velocity measurements, to name a few.

With our discussion of the magnetic flowmeter and method for measuring the conductivity of a fluid media complete. We'll now shift our attention to a commercial implementation of the flow meter.

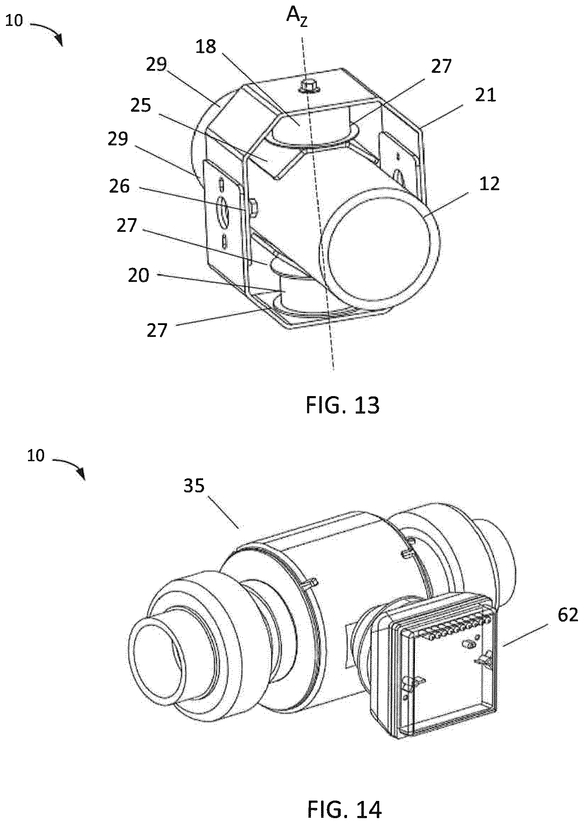

With reference now to FIG. 13, the magnetic flow meter assembly 10 includes a pair of coil assemblies (18, 20) which are coupled to the pipe 12 in an intermediate region thereof. The coil assemblies are mounted external to the pipe, aligned along the axis (Az). More particularly, each coil is held in place by a brace 21 that circumscribes the pipe 12. A magnetic pole 25 is disposed between the coil 18 and the pipe. The magnetic pole is formed of conductive material, e.g., metal same as the magnetic brace, soft magnetic Carbon Steel with Fe% > 99.4, and shaped to conform about the pipe. Nonconductive (airgap) shims 27 are disposed on opposing ends of the coils. With each coil, a first airgap shim 27 is sandwiched between the coil and the corresponding magnetic pole 25, and a second airgap shim 27 is sandwiched between the coil and the brace 21. In each coil, there is a core made of a material with good magnetic properties. These cores are transferring the flux lines from the coils into the pole shoes and the magnetic brace.

The brace 21 further serves as magnetic circuitry for the magnetic field generated by the coils 18, 20. The brace has a generally octagonal shape, which benefits the assembly and operation of the assembly 10. More particularly, the brace 21 is formed of two, generally c-shaped components 29 that slide-ably mates with each other about the pipe, to couple to each other. In this manner, the brace 21 can be used on pipes having different diameters. Attachments (e.g., bolts) couple the coils to the brace along the axis (Az).

The assembly 10 is configured to generate a strong alternating magnetic field (flux) B that is distributed evenly over the pipe's cross-section. Utilizing an alternating magnetic field avoids electrode material migration. Configuration of the brace 21, e.g., including shape and materials, facilitates the resulting magnetic field (flux) B within the pipe 12. In the exemplary embodiment the brace 21 is formed "soft" magnetic materials, which refers to relative permeability, meaning is has no remnant magnetization, when shut down.

With reference now to FIG. 14, the magnetic flow meter assembly 10 further includes a housing 35 configured to protect the magnetic field generator (which includes the coils 18, 20 and the brace 21), from environmental exposure. The assembly 10 further includes an electronics assembly 62 attached to the housing of the assembly. The electronics assembly 62 is in electrical communication with the electrodes (19, 26) and the coils (18, 20) of the assembly to operate the assembly. In an exemplary embodiment, the electronics assembly can house components such as drivers (32, 34), op amps (40, 42), A to D converters (ADC) (44, 46), micro-processor 48, and a pule width modulator (PWM) 50, among others.

The present invention has been described above in terms of presently preferred embodiments so that an understanding of the present invention can be conveyed. However, there are other embodiments not specifically described herein for which the present invention is applicable. Therefore, the present invention should not to be seen as limited to the forms shown, which is to be considered illustrative rather than restrictive.

**Claims**

1.  A method for operating a flowmeter, the flowmeter configured to measure the velocity of a conductive fluid in a flow path, the method comprising:

    driving at least one coil assembly with a drive current provided by a coil driver, the at least one coil assembly located adjacent to the fluid flow path;
    measuring an electrical property associated with the conductive fluid in the fluid flow path;
    determining an electrical conductivity of the fluid based on the measured electrical property; and
    modifying a frequency of the drive current responsive to the electrical conductivity of the fluid to optimize a measurement rate of the flowmeter.

2.  The method as defined in claim 1, wherein the driving at least one coil assembly comprises alternating the drive current to induce a magnetic field in the at least one coil assembly.

3.  The method as defined in claim 1, wherein measuring an electrical property associated with the conductive fluid comprises measuring a peak voltage ($U_E$ Peak) induced in the conductive fluid responsive to a magnetic field in the at least one coil assembly.

4.  The method as defined in claim 3, wherein determining an electrical conductivity of the fluid based on the measured electrical property comprises determining the fluid's electrical conductivity from a relationship between the peak voltage measurement and the fluid's electrical conductivity.

5.  The method as defined in claim 4, wherein the relationship between the peak voltage measurement and electrical conductivity value are non-linear.

6.  The method as defined in claim 1, wherein modifying a frequency of the drive current comprises increasing the drive current frequency for highly conductivity fluids and decreasing the drive current frequency for less conductivity fluids.

7.  The method as defined in claim 1, wherein modifying a frequency of the drive current comprises:

    comparing the fluid's electrical conductivity to a minimum fluid conductivity value; and
    not performing a fluid velocity measurement if the fluid's electrical conductivity is below the minimum fluid conductivity value.

8.  A device for operating a flowmeter configured to measure the velocity of a conductive fluid in a flow path, the device comprising:

    at least one coil driver configured to provide a drive current to a coil assembly;
at least one electrode configured to measure an electrical signal created by the conductive fluid flowing through a magnetic field created by the drive current in the coil assembly; and
a computer processor configured to:

> determine an electrical conductivity of the fluid responsive to the electrical signal; and
> modify a frequency of the drive current responsive to the electrical conductivity of the fluid to optimize the measurement frequency of the flowmeter.

**9.** The device as defined in claim 8, wherein the coil driver alternates the drive current to create a magnetic field in the coil assembly.

**10.** The device as defined in claim 8, wherein the at least one electrode measures a peak voltage ($U_E$ Peak) created by the conductive fluid flowing through a magnetic field created by the coil assembly.

**11.** The device as defined in claim 10, wherein the computer processor determines the electrical conductivity of the fluid using a mathematical relationship between the peak voltage measurement and the fluid's electrical conductivity.

**12.** The device as defined in claim 11, wherein the mathematical relationship between the peak voltage and electrical conductivity is approximately log rhythmic.

**13.** The device as defined in claim 8, wherein the computer processor modifies the frequency of the drive current by increasing the drive current frequency for conductive fluids and decreasing the drive current frequency for less conductive fluids.

**14.** A non-transient computer readable storage medium comprising computer executable instructions that when executed by a computer processor performs a method, comprising:

> energizing at least one coil assembly with a drive current provided by a coil driver, the at least one coil assembly located proximate to a fluid flow path;
> measuring an electrical property of the conductive fluid in the fluid flow path;
> determining an electrical conductivity of the fluid based on the measured electrical property; and
> adjusting a frequency of the drive current responsive to the electrical conductivity of the fluid to optimize a measurement frequency of a magnetic flowmeter.

**15.** The non-transient computer readable storage medium as defined in claim 14, wherein determining an electrical conductivity of the fluid based on the measured electrical property comprises using a relationship between a peak voltage measurement and a fluid's electrical conductivity to determine the electrical conductivity value, in particular, the relationship between the peak voltage measurement and the fluid's electrical conductivity is a non-linear relationship, preferably, the relationship between the peak voltage measurement and electrical conductivity is approximately a log rhythmic relationship.

FIG. 1

FIG. 2

Delta $U_E$ Peak vs. Fluid Conductivity

Fluid Conductivity C (μS/cm)

FIG. 3

40

Coil #1 20

12

Fluid Flow lines $\overrightarrow{V}$ 18

Magnetic flux lines $\overrightarrow{B}$ 28

Electrode #1 30

Electrode #2 32

$U_{E1}$

$U_{E2}$

Coil #2 22

24

Driver #1

26

Driver #2

42

46

Signal Cond

50

Instr Amp

52

A/D

36

Micro Controller

44

48

Signal Cond

FIG. 4

FIG. 5

FIG. 6

FIG. 7

FIG. 8

FIG. 9

FIG. 10

FIG. 11

FIG. 12

FIG. 12

FIG. 13

FIG. 14

Europäisches
Patentamt

European
Patent Office

Office européen
des brevets

# EUROPEAN SEARCH REPORT

**Application Number**

EP 20 15 0468

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2014/260662 A1 (ROGERS STEVEN BRUCE [US] ET AL) 18 September 2014 (2014-09-18) | 1-3,6, 8-10,13, 14 | INV. G01F1/58 G01F1/60 |
| Y | * paragraphs [0005], [0006], [0015] - [0037]; figures 1, 2B, 3, 4 * | 4,5,11, 12,15 | ADD. G01N27/08 |
| X | US 4 969 363 A (MOCHIZUKI TSUTOMU [JP]) 13 November 1990 (1990-11-13) * column 3, line 4 - column 4, line 18 * * column 5, line 38 - column 6, line 8 * * column 7, line 28 - column 8, line 20; figures 3, 7 * | 1,2,7-9, 14 | |
| Y | US 2018/245956 A1 (MOMOSE OSAMU [JP]) 30 August 2018 (2018-08-30) * paragraphs [0016], [0090], [0121]; figure 7 * | 4,5,11, 12,15 | |
| Y | US 9 285 256 B1 (CHANG MING-HUI [TW] ET AL) 15 March 2016 (2016-03-15) * column 6, line 53 - column 7, line 13; figure 5 * | 12 | TECHNICAL FIELDS SEARCHED (IPC) |
| A | US 2008/262796 A1 (RUFER HEINZ [CH] ET AL) 23 October 2008 (2008-10-23) * paragraphs [0057] - [0071]; figure 7 * | 1-15 | G01F G01N |

The present search report has been drawn up for all claims

| Place of search | Date of completion of the search | Examiner |
|---|---|---|
| The Hague | 28 April 2020 | Myrillas, K |

EPO FORM 1503 03.82 (P04C01)

## ANNEX TO THE EUROPEAN SEARCH REPORT
## ON EUROPEAN PATENT APPLICATION NO.

EP 20 15 0468

This annex lists the patent family members relating to the patent documents cited in the above-mentioned European search report.
The members are as contained in the European Patent Office EDP file on
The European Patent Office is in no way liable for these particulars which are merely given for the purpose of information.

28-04-2020

| Patent document cited in search report | | Publication date | Patent family member(s) | | Publication date |
|---|---|---|---|---|---|
| US 2014260662 | A1 | 18-09-2014 | CN 104048710 A | | 17-09-2014 |
| | | | EP 2972123 A1 | | 20-01-2016 |
| | | | JP 6364470 B2 | | 25-07-2018 |
| | | | JP 2016511425 A | | 14-04-2016 |
| | | | US 2014260662 A1 | | 18-09-2014 |
| | | | WO 2014159865 A1 | | 02-10-2014 |
| US 4969363 | A | 13-11-1990 | DE 68907628 D1 | | 26-08-1993 |
| | | | DE 68907628 T2 | | 04-11-1993 |
| | | | EP 0336615 A1 | | 11-10-1989 |
| | | | JP 2568620 B2 | | 08-01-1997 |
| | | | JP H01248022 A | | 03-10-1989 |
| | | | US 4969363 A | | 13-11-1990 |
| US 2018245956 | A1 | 30-08-2018 | CN 108507632 A | | 07-09-2018 |
| | | | JP 2018141667 A | | 13-09-2018 |
| | | | US 2018245956 A1 | | 30-08-2018 |
| US 9285256 | B1 | 15-03-2016 | NONE | | |
| US 2008262796 | A1 | 23-10-2008 | CN 101652638 A | | 17-02-2010 |
| | | | DE 102007014469 A1 | | 25-09-2008 |
| | | | DK 2245430 T3 | | 23-10-2017 |
| | | | EP 2245430 A2 | | 03-11-2010 |
| | | | JP 4977766 B2 | | 18-07-2012 |
| | | | JP 2010521690 A | | 24-06-2010 |
| | | | US 2008262796 A1 | | 23-10-2008 |
| | | | WO 2008113774 A2 | | 25-09-2008 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 16146090 B